# EUROPEAN PATENT APPLICATION

(11) **EP 1 302 247 A1**
(43) Date of publication of application: **16.04.2003**
(21) Application number: 01124415.9
(22) Date of filing: 11.10.2001
(51) Int. Cl.: B05C 1/08, H05K 3/00

(54) **Device for plugging holes in printed circuit boards**

(71) Applicant: G.I.T. Co., Ltd., Tokyo (JP)
(72) Inventor: Takayanagi, Tadashi, Tokyo (JP)
(74) Representative: Stenger, Watzke & Ring Patentanwälte

(57) **Abstract**

There is disclosed an improvement for a device for plugging holes in printed circuit boards with a plugging substance comprising a reservoir (7) for containing a liquid plugging substance (8), roller means (4) for applying said liquid plugging substance (8) onto a surface of a printed circuit boards (1) said roller means (4) being arranged to contact with a first portion of a lateral surface thereof said liquid plugging substance (8) contained in said reservoir (7) and to contact with a second portion of said lateral surface the surface of the printed circuit board (1) along an application area and said roller means being rotatable around an axis of rotation (5) extending substantially parallel to the longitudinal extension of said roller means (4) in a direction of rotation (6), and means for moving a printed circuit board (1) in a moving direction (2) substantially transverse to that longitudinal extension of the roller means (4). To improve such a device in such a manner that it allows to prevent plugging of reference holes in the printed circuit board (1) in an easy and inexpensive way the device is characterised in that it further comprises at least one scraper means (10) contacting the lateral surface of the roller means (4) in a preselected area said scraper means (10) being located before the application area seen in said direction of rotation (5) in an intermediate position between said reservoir (7) and said application area for at least partially removing the liquid plugging substance (8) from the lateral surface of the roller means (4) in said preselected area before the latter contacts the surface of the printed circuit board (1).

## Description

The present invention relates to a device for plugging holes in printed circuit boards (PCB) with a plugging substance comprising: a reservoir for containing a liquid plugging substance, roller means for applying said liquid plugging substance onto a surface of a PCB said roller means being arranged to contact with a first portion of a lateral surface thereof said liquid plugging substance contained in said reservoir and to contact with a second portion of said lateral surface the surface of the PCB along an application area and said roller means being rotatable around an axis of rotation extending substantially parallel to the longitudinal extension of said roller means in a direction of rotation, and means for moving a PCB in a moving direction substantially transverse to said longitudinal extension of the roller means.

In the field of electronics printed circuit boards or shortly PCB's are used to assemble componentries which contain electronic circuits comprising several electric or electronic devices such as resistors, microprocessors, microcontrollers, memory chips, inductors and the like. According to the particular design of the electric or electronic circuit desired electrically conductive pathways are formed on a substrate usually consisting of a resin material such as epoxy. To make the PCB's smaller so called multilayered PCB's have been used with several layers arranged in a sandwich like structure therein each of the layers containing electrically conductive pathways. The electrically conductive pathways usually are formed of a conductive material such as copper, gold, carbon or the like.

For such multilayered PCB's it is necessary to drill so called via holes to contact electrically conductive pathways of one layer with corresponding electrically conductive pathways of another layer. Such via holes may extend only partially through the PCB or might cross the entire thickness of the PCB. After the contacts between layers have been formed these via holes must be plugged again to avoid short cuts or other undesired conditions and to protect the internal layers. Plugging of these holes is typically done with a device as described above. The roller means typically a cylindrical roller is rotated around its axis of rotation thereby taking up some of the liquid plugging substance, e.g. ink, liquid resin solution, lacquer or the like. The liquid plugging substance sticks to the lateral surface of the roller means and thus is transported to the application area where the lateral surface of the roller means contacts the PCB to be plugged. The PCB is firmly pressed against the roller means and the via holes are filled with the liquid plugging substance and thus plugged.

Besides the via holes PCB's typically comprise additional holes called reference holes and usually extending across the entire thickness of the PCB which holes are used for orientation purposes during the several steps of the automated manufacturing process for assembling the several electric or electronic devices on the PCB. These reference holes usually are sited along the margin of the PCB's and shall not be plugged.

One method known in the art for preventing plugging of the reference holes is to simply cover them with strips of a thin self adhesive material, e.g. an adhesive tape. This approach is unsatisfying as it is labour intensive and thus expensive.

Another approach for preventing the plugging of reference holes with a device as described above is disclosed in the German utility model DE 200 06 693 U1. With this device the width of the application area of a plugging substance onto the surface of the PCB is adjusted by using different rollers with different lengths. For PCB's with different width of the area the liquid plugging substance has to be applied on different rollers with different sizes have to be used. Thus the application roller for the plugging substance has to be exchanged for each change of PCB's to be processed. For such a device a couple of different rollers have to be kept on stock and a labour intensive and time consuming exchange of the rollers has to be performed for each change of a type of PCB to be processed. This approach also is unsatisfying in being complicated and expensive.

Accordingly it is an object of the invention to improve a device for plugging holes in printed circuit boards of the kind as described above in a way that reference holes can be prevented from being plugged in an easier and less expensive manner than compared with the approaches known from the prior art.

To achieve this object the device for plugging holes in printed circuit boards according to the present invention is characterised in that the device further comprises at least one scraper means contacting the lateral surface of the roller means in a preselected area said scraper means being located before the application area seen in the direction of rotation in an intermediate position between the reservoir and the application area for at least partially removing the liquid plugging substance from the lateral surface of the roller means in said preselected area before the latter contacts the surface of the printed circuit board.

By providing the scraper means and locating them in the manner described the liquid plugging substance can be removed from the lateral surface of the roller means in the portion of the roller means that the scraper means is contacting. The scraper means is arranged in a position behind the spot where the lateral surface of the rotating roller means exists the reservoir of the liquid plugging substance but before the application area where the liquid plugging substance is transferred from the lateral surface of the roller means onto the surface of the PCB. Thus the lateral surface of the roller means which exits the reservoir completely covered with the liquid plugging substance gets freed of the substance in the part the scraper means contacts the lateral surface in. The scraper means will be positioned such that an area of the PCB containing the reference holes will not be coated with the liquid plugging substance along the entire length of the PCB when the length of the PCB is that dimension extending in parallel to the moving direction. The scraper means thus is a simple and inexpensive tool to avoid plugging of reference holes particularly of those reference holes sited at the side margins of the PCB (when the side margins are those margins in parallel with the moving direction of the PCB in the device).

A preferred form of the scraper means is a scraper means of an elongated form which is oriented substantially parallel to the longitudinal extension of the roller means. Such a scraper means may be simply and easily manufactured with a minimum use of material to achieve a maximum effort.

Preferably a position of the scraper means is adjustable in a direction substantially parallel to said longitudinal extension of the roller means for determining the preselected area of the lateral surface of the roller means from which the liquid plugging substance is removed. With such an adjustable position in the described direction it is possible to simply modify the position of the scraper means when another type of PCB is to be processed. The roller means of the device remains unchanged, just the position of the scraper means along the longitudinal extension of the roller means will be adjusted according to the particular dimensions of the PCB and the margin equipped with the reference holes. By means of this feature there is no need to change the roller means or to keep roller means of different dimensions, particularly different length.

According to another advantageous improvement of the present invention a position of the scraper means is adjustable in a radial direction with respect to the roller means for adjusting a pressing force with which the scraper means is forced onto the lateral surface of the roller means. The ability to adjust the pressing force enables the user of the device of the present invention to adjust the pressing force in a way that the scraper reliably removes the liquid plugging substance without exerting excessive pressing force and breaking the roller means by means of excessive friction.

According to another preferred embodiment of the present invention the scraper means is located in such a position that surplus liquid plugging substance removed from the lateral surface of the roller means returns to the reservoir. By means of this feature no liquid plugging substance is wasted, the liquid plugging substance removed from the lateral surface of the roller means may be reused. A simple arrangement that allows a recovery of the liquid plugging substance removed is given if as suggested the reservoir is located underneath the at least one scraper means so that surplus liquid plugging substance removed from the lateral surface of the roller means drops back into the reservoir.

As the scraper means may suffer from wear and may loose its efficiency over time the scraper means according to another preferred embodiment of the invention is mounted in the device in an exchangeable manner. Whenever the scraper means looses effectiveness it might be exchanged then.

According to another preferred embodiment the scraper means comprises a scraping element contacting lateral surface of the roller means wherein the scraping element is made of a soft material. This scraping element may be made of rubber, plastics or any other suitable soft polymer. With the scraping element of such a soft material a scraping action of maximum effort can be achieved. The liquid plugging substance sticking to the lateral surface of the roller means may be removed most efficiently with the use of such a scraping element without harming the roller means itself.

According to another preferred embodiment of the invention the device comprises two or more scraper means wherein each of the scraper means contacts the lateral surface of the roller means in a predetermined area. By means of the provision of two or even more scraper means the plugging of reference holes in several spaced apart areas of the PCB may efficiently be performed. As in most of the cases reference holes are cited to both of the side margins (those margins extending in parallel to the moving direction of the PCB) it is preferred that the device comprises at least two scraper means which two scraper means are located at respective end parts of the roller means.

Further features and advantages will become clear to a person skilled in the art when reading through the following description of preferred embodiments in which description references made to the accompanying drawing. In the drawings:
- Figure 1:: schematically shows a side view schematically showing essential elements of the device of the present invention; and
- Figure 2:: shows a schematic back view of an applying unit for applying a liquid plugging substance as seen in a moving direction of a PCB.

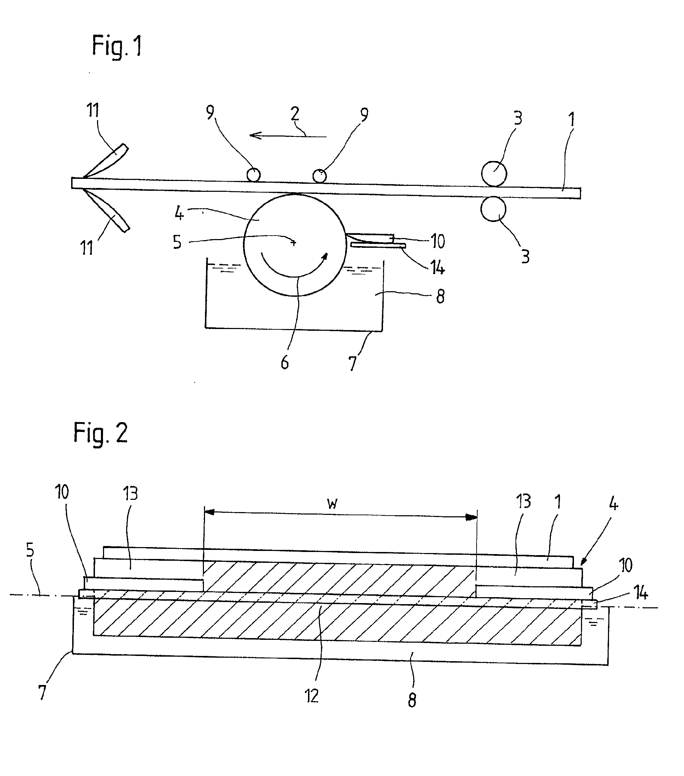

Figure 1 shows in a schematic side view the major parts of an embodiment of the device for plugging holes in printed circuit boards according to the present invention. A printed circuit board 1 is moved through the device in a moving direction 2 driven by transport rollers 3. An application roller 4 which is rotatable around an axis 5 of rotation in a direction 6 of rotation contacts a lower surface of the printed circuit board 1. With a lower portion the application roller 4 immerses into a liquid plugging substance 8, e.g. an ink liquid resin solution, a liquid polymer solution, a lacquer or the like, contained in a reservoir 7. Counterpressure rollers 9 fix the PCB 1 and hold it firmly against the lateral surface of the application roller 4. In an intermediate position between the reservoir 7, particularly the level of the liquid plugging substance 8 in the reservoir 7, and the lower surface of the PCB 1, particularly a contacting area between the lateral surface of the roller 4 and the lower surface of the PCB 1, and before the contacting area when seen in direction 6 of rotation is located a scraper 10 which contacts the lateral surface of the application roller 4 in a preselected area. The scraper 10 is fixed to an adjustment plate 14 in a releasable manner.

With respect to the moving direction 2 of the application roller 4 squeezers 11 are provided after the application roller 4 contacting the upper and lower surfaces of PCB 1. The squeezers 11 extend substantially transverse to moving direction 2 and substantially along the entire width of PCB 1.

For applying the liquid plugging substance 8 to the PCB 1 the PCB 1 is moved in moving direction 2 transverse to the longitudinal extension of the application roller 4 over the application roller 4. The PCB 1 is driven by transport rollers 3. The application roller 4 which is partially immersed into the liquid plugging substance 8 in the reservoir 7 takes up some of the liquid plugging substance 8 which sticks to the lateral surface of application roller 4. When rotating in moving direction 6 the application roller 4 conveys the liquid plugging substance 8 stuck to its lateral surface to the lower surface of the PCB 1 and applies it thereto in an application area, where the lateral surface of the application roller 4 contacts the lower surface of PCB 1. For adjusting the amount of plugging substance 8 to be applied the adjustment plate 14 is provided. The adjustment plate 14 extends substantially parallel to the application roller 4 along the entire length of the latter. Between the adjustment plate 14 and the lateral surface of the application roller 4 there exists an adjustable gap. The gap can be adjusted so as to determine the amount of plugging substance 8 to be applied. Surplus plugging substance 8 is removed by the adjustment plate 14 and drops back into the reservoir 7. To assure firm contact between the application roller 4 and the PCB 1 the counterpressure rollers 9 are provided. To avoid plugging of reference holes typically located at the margin of the PCB 1 extending parallel to moving directions 2 one or more scrapers 10 are provided which contact the lateral surface of the roller 4 to remove the liquid plugging substance 8 stuck to the lateral surface of the application roller 4 in a predetermined area. As the liquid plugging substance 8 is removed from the lateral surface of the application roller 4 in the predetermined area no substance 8 will be applied to corresponding areas of the lower surface of PCB 1. In this area no plugging of reference holes located therein will occur.

Finally the squeezers 11 which contact both, the upper and the lower surface of the PCB 1 remove surplus plugging substance remaining on the surfaces of the PCB 1 after the via holes have been plugged.

The PCB 1 is inserted and moved through the device with the surface having the openings of the via holes oriented downwards into the direction of the application roller 4.

The material of scraper 10 and squeezers 11 in at least their tip sections is soft material suitable for a firm contact between the scraper 10 or squeezers 11 and the lateral surface of roller 4 or the surfaces of the PCB 1 respectively. Preferred materials of choice are e.g. rubber, soft polymers, or similar materials soft enough to provide a firm and tight contact with the surfaces to scrape or squeeze.

The scraper 10 is adjustable in a position radially with respect to the application roller 4 to adjust the pressing force with which the squeezer 10 contacts a lateral surface of the application roller 4. This is to enable an operator to adjust the scraper 10 in a manner that it reliably removes the liquid plugging substance 8 from the lateral surface of the application roller 4 in a preselected area but not to induce an excessive friction, causing an excessive wear of the scraper 10 tip and increasing power consumption of the system.

In figure 2 there is schematically shown another view of important parts of the embodiment shown in figure 1 seen from the right hand side as displayed in figure 1. In this figure it can be seen that there are provided two scrapers 10 located in both of the end portions of the application roller 4 fixed to the ink adjustment plate 14 in a releasable manner. The scrapers 10 are of substantially elongated form and extend substantially parallel to the longitudinal extension of the application roller 4 or parallel to the axis of rotation 5 respectively. From this figure it can also be seen that the lateral surface of the application roller 4 picks up some of the liquid plugging substance 8 from the reservoir 7 indicated by the hatch lines. The ink volume adjustment plate 14 adjusts the ink level on the lateral surface of the application roller 4 and the scrapers 10 remove the liquid plugging substance 8 from the lateral surface of the application roller 4 in areas 13. Only in area 12 there remains liquid plugging substances 8 on the lateral surface of the application roller 4 and will be applied to the lower surface of PCB 1. This area 12 has a width as indicated with w in the figure.

The width w is adjustable by adjusting the position of the scrapers 10 in a direction substantially parallel to the longitudinal extension of the application roller 4. This is achieved by the scrapers 10 being arranged in a longitudinal groove of the adjustment plate 14 which groove extends substantially parallel to the longitudinal extension of the application roller 4. Such a groove does not necessarily need to be located on the adjustment plate 14 but may be located in other parts of the device not displayed in the schematic drawings.

If desired, more than the displayed two scrapers 10 may be provided e.g. three or even more. The scrapers 10 preferably are fixed to the device in an exchangeable manner to enable an operator to exchange scrapers 10 fast and easily whenever necessary.

With the present invention there has been provided an improved device for plugging holes in printed circuit boards with a plugging substance which allows to prevent reference holes from being plugged in an easy, inexpensive and reliable manner. Compared to the state of the art systems the device of the present invention is more simple, less labour-intensive and reduces the need for additional parts.

### List of reference numbers

- 1: printed circuit board (PCB)
- 2: moving direction
- 3: transport roller
- 4: application roller
- 5: axis of rotation
- 6: direction of rotation
- 7: reservoir
- 8: plugging substance
- 9: counterpressure roller
- 10: scraper
- 11: squeezer
- 12: area
- 13: area
- 14: adjustment plate
- w: width

## Claims

1. Device for plugging holes in printed circuit boards with a plugging substance comprising:
a reservoir (7) for containing a liquid plugging substance (8);
roller means (4) for applying said liquid plugging substance (8) onto a surface of a printed circuit board (1) said roller means (4) being arranged to contact with a first portion of a lateral surface thereof said liquid plugging substance (8) contained in said reservoir (7) and to contact with a second portion of said lateral surface the surface of the printed circuit board (1) along an application area and said roller means (4) being rotatable around an axis of rotation (5) extending substantially parallel to the longitudinal extension of said roller means in a direction of rotation (6); and
means (3) for moving a printed circuit board (1) in a moving direction (2) substantially transverse to said longitudinal extension of the roller means (4),
**characterised in that**
the device further comprises at least one scraper means (10) contacting the lateral surface of the roller means (4) in a preselected area said scraper means (10) being located before the application area seen in said direction of rotation (6) in an intermediate position between said reservoir (7) and said application area for partially removing the liquid plugging substance (8) from the lateral surface of the roller means (4) in said preselected area before the latter contacts the surface of the printed circuit board (1).

2. Device according to claim 1, **characterised in that** said at least one scraper means (10) has an elongated form and is oriented substantially parallel to said longitudinal extension of the roller means (4).

3. Device according to any of the preceding claims, **characterised in that** a position of said at least one scraper means (10) is adjustable in a direction substantially parallel to said longitudinal extension of the roller means (4) for determining said preselected area of said lateral surface of the roller means (4) from which said liquid plugging substance (8) is removed.

4. Device according to any of the preceding claims, **characterised in that** a position of said at least one scraper means (10) is adjustable in a radial direction with respect to said roller means (4) for adjusting a pressing force with which said at least one scraper means (10) is forced onto said lateral surface of the roller means (4).

5. Device according to any of the preceding claims, **characterised in that** the at least one scraper means (10) is located in such a position that surplus liquid plugging substance (8) removed from said lateral surface of the roller means (4) returns to said reservoir (7).

6. Device according to claim 5, **characterised in that** the reservoir (7) is located underneath the at least one scraper means (10) so that surplus liquid plugging substance (8) removed from said lateral surface of the roller means (4) drops back into said reservoir (7).

7. Device according to any of the preceding claims, **characterised in that** said at least one scraper means (10) is mounted in the device in an exchangeable manner.

8. Device according to any of the preceding claims, **characterised in that** said at least one scraper means (10) comprises a scraping element contacting said lateral surface of the roller means (4) wherein said scraping element is made of a soft material.

9. Device according to claim 8, **characterised in that** said scraping element is made of rubber, plastics or any other suitable soft polymer.

10. Device according to any of the preceding claims, **characterised in that** it comprises two or more scraper means (10) each of the scraper means (10) contacting said lateral surface of the roller means (4) in a predetermined area.

11. Device according to claim 10, **characterised in that** it comprises at least two scraper means (10) which two scraper means (10) are located at respective end parts of said roller means (4).
